# EUROPÄISCHE PATENTSCHRIFT

(11) **EP 2 893 786 B1**
(45) Veröffentlichungstag und Bekanntmachung des Hinweises auf die Patenterteilung: **01.03.2017**
(21) Anmeldenummer: 13756858.0
(22) Anmeldetag: 28.08.2013
(51) Int. Cl.: H05K 7/14

(54) **ELEKTRONISCHES GERÄT MIT EINEM GEHÄUSE ZUR AUFNAHME ELEKTRONISCHER KOMPONENTEN, VORZUGSWEISE EIN PROZESSTRANSMITTER**
ELECTRONIC DEVICE COMPRISING A HOUSING FOR RECEIVING ELECTRONIC COMPONENTS, PREFERABLY A PROCESS TRANSMITTER
APPAREIL ÉLECTRONIQUE COMPRENANT UN BOÎTIER DESTINÉ À RECEVOIR DES COMPOSANTS ÉLECTRONIQUES, DE PRÉFÉRENCE UN ÉMETTEUR DE PROCESSUS

(30) Priorität: 10.09.2012 DE 102012108414
(43) Veröffentlichungstag der Anmeldung: 15.07.2015
(73) Patentinhaber: Endress+Hauser Flowtec AG, 4153 Reinach (BL) (CH)
(72) Erfinder: FINK, Nikolai, CH-4147 Aesch (CH); MOSER, Thiérry, F-68510 Sierentz (FR); ENGSTLER, Gernot, CH-4125 Riehen (CH); KOUDAL, Ole, CH-5452 Oberrohrdorf (CH)
(74) Vertreter: Andres, Angelika Maria
(86) Internationale Anmeldenummer: PCT/EP2013/067778
(87) Internationale Veröffentlichungsnummer: WO 2014/037256

(56) Entgegenhaltungen:
- DE-A1- 19 822 564
- DE-U1- 20 219 684
- US-A- 5 941 282
- US-A1- 2008 123 259

## Beschreibung

Die Erfindung betrifft ein elektronisches Gerät mit einem Gehäuse zur Aufnahme elektronischer Komponenten, vorzugsweise ein Prozesstransmitter, wobei das Gehäuse zwei Kammern aufweist, in denen elektronische Komponenten und Benutzerschnittstellen und/oder Anschlusselemente für Kabel angeordnet sind, wobei die elektronischen Komponenten in einer ersten Kammer angeordnet sind.

Prozesstransmitter, wie sie beispielsweise in der Prozessleittechnik, insbesondere in der chemischen Industrie, eingesetzt werden, umfassen verschiedene elektronische Komponenten, wie beispielsweise einen Feldbus, eine Messtechnik oder Module zur Ein- und Ausgabe analoger elektrischer Signale sowie ein Netzteil. Um diese elektronischen Komponenten für den jeweiligen Anwendungsfall programmieren oder warten zu können, sind Benutzerschnittstellen vorhanden. Über Anschlussklemmen werden die elektronischen Komponenten mit externen Geräten verbunden. Das Gehäuse des Prozesstransmitters ist dabei als Einkammergehäuse ausgebildet, in welchem die elektronischen Komponenten gemeinsam mit den Benutzerschnittstellen und den Anschlusselementen angeordnet sind. Es sind aber auch Zweikammergehäuse bekannt, bei denen die Anschlusselemente in einer ersten Kammer des Gehäuses positioniert sind, während die elektronische Komponenten und die Benutzerschnittstellen in der zweiten Kammer angeordnet sind.

Diese Gehäusekonstruktion hat den Nachteil, dass der Nutzer bei der Programmierung oder Wartung des Prozesstransmitters immer beide Gehäusekammern öffnen muss. Das bedeutet, dass die elektronischen Komponenten bei der Öffnung der Kammer Umwelteinflüssen ausgesetzt sind. Des Weiteren ist es bei einer solchen Zweikammerkonstruktion des Gehäuses des Prozesstransmitters notwendig, dass dem Nutzer des Prozesstransmitters immer Zugang von zwei Seiten zu dem Gehäuse gewährt werden muss, was erhöhte Anforderungen an die Einbaulage des Gehäuses am Einsatzort stellt.

Dokument US2008/123259 offenbart eine Vorrichtung, die einen druckfesten Innenraum und eine Aussparung auf der Außenseite umfasst. Der druckfeste Innenraum enthält elektronische Bauteile und die Aussparung nimmt eine Anzeige- und Bedienkomponente auf.

Der Erfindung liegt somit die Aufgabe zugrunde, ein elektronisches Gerät mit einem Gehäuse zur Aufnahme elektronischer Komponenten anzugeben, bei welchem der Nutzer einfachen Zugriff zu den Benutzerschnittstellen bzw. Anschlusselementen hat, wobei die elektronische Komponenten vor Umwelteinflüssen zuverlässig geschützt sind.

Erfindungsgemäß wird die Aufgabe dadurch gelöst, dass in der ersten Kammer ausschließlich elektronische Komponenten angeordnet sind, während Benutzerschnittstellen der elektronischen Komponenten und/oder Anschlusselemente für Kabel ausschließlich in der zweiten Kammer positioniert sind. Aufgrund der Anordnung der Benutzerschnittstellen und der Anschlusselemente für Kabel in einer gemeinsamen Kammer muss dem Nutzer nur Zugang zu dieser einen Kammer gewährt werden, wenn der Prozesstransmitter gewartet oder für einen bestimmten Messvorgang justiert werden soll. Darüber hinaus besteht der Vorteil, dass sich der Einbau des Gehäuses am Einsatzort vereinfacht, da der Nutzer nur Zugang zu einer Kammer und somit nur von einer Seite benötigt.

Vorteilhafterweise sind die Benutzerschnittstellen und/oder die Anschlusselemente in der zweiten Kammer auf einem Trägerelement angeordnet, welches durch eine Gehäusedurchführung in die erste Kammer ragt, wo das Trägerelement von einer Steckeinrichtung in der ersten Kammer mechanisch aufgenommen ist, welche die auf dem Trägerelement geführten elektrischen Leitungen der Benutzerschnittstellen und/oder der Anschlusselemente elektrisch mit den jeweiligen elektronischen Komponenten verbindet. Durch diese Trägerplatte wird der mechanische Aufwand für die Schnittstelle reduziert, da auf eine Verbindung von vielen Kabeln zwischen der ersten und der zweiten Kammer verzichtet werden kann. Diese Verbindung ist insbesondere dann geeignet die erste Kammer mit der zweiten Kammer elektrisch zu verbinden, wenn die erste Kammer besonders strengen Anforderungen hinsichtlich des Explosionsschutzes genügen muss, während an die zweite Kammer nur geringfügige Anforderungen an den Explosionsschutz gestellt werden. In Konfigurationen, in denen die Trennung der Kammern nicht derart strikt erfüllt werden muss, kann das Trägerelement auch als mechanische Trennwand für die beiden Kammern eingesetzt werden. Das Trägerelement ist dann derart gestaltet, dass die beiden Kammern voneinander isoliert sind. Dies beinhaltet einen Schutz nach IP sowie eine Isolation im Sinne von Elektromagnetismus. Die Steckeinrichtung, welche mit dem Trägerelement verbunden ist, ist dabei in der explosionsfesten ersten Kammer angeordnet. Dies hat den Vorteil, dass die Abstände der elektrischen Leitungen innerhalb der Steckeinrichtung geringer ausgebildet sein können. Die Steckeinrichtung ermöglicht somit in der ersten Kammer neben der mechanischen Aufnahme des Trägerelementes gleichzeitig die elektrische Verbindung zwischen den, auf dem Trägerelement in der zweiten Kammer angeordneten Benutzerschnittstellen und/oder Anschlusselementen mit den elektrischen Komponenten in der ersten Kammer.

In einer Ausgestaltung ist die Gehäusedurchführung druckfest abgedichtet. Dadurch wird verhindert, dass eine eventuell in der ersten Kammer auftretende Explosion, welche durch eine Funkenentladung entstehen kann, sich auf die zweite Kammer ausweitet.

In einer Weiterbildung führen die Benutzerschnittstellen an eine in der zweiten Kammer, vorzugsweise auf dem Trägerelement, angeordnete Schaltlogik, welche die elektrischen Signale der Benutzerschnittstellen mittels einer digitalen Kommunikation seriell an die jeweiligen elektronischen Komponenten in der ersten Kammer weiterleitet. Durch den Einsatz dieser Schaltlogik wird verhindert, dass eine oder mehrer elektrische Leitungen jeder Benutzerschnittstelle separat über das Trägerelement durch die Gehäusedurchführung in die erste Kammer geführt werden müssen, was die Anzahl der Schnittstellen erhöhen würde. Da die Benutzerschnittstellen auf die Schaltlogik geführt und von dieser gebündelt werden, ist es möglich, die Gehäusedurchführung relativ klein zu halten, wodurch die Kosten für die Herstellung des Gehäuses reduziert werden.

In einer Variante weisen die, auf dem Trägerelement ausgebildeten Leitungen einen Abstand auf, welcher eine gegenseitige elektromagnetische Beeinflussung der übertragenen schnellen elektrischen Signale unterbindet. Da die Anzahl der Leitungen hinter der Schaltlogik wesentlich reduziert ist, ist es problemlos möglich, diese die Schaltlogik verlassenden Leitungen, in einem entsprechenden Abstand auf der Leiterplatte anzuordnen, zumal die Schaltlogik für die Ausführung von digitalen Signalen nur wenig Strom benötigt.

In einer erweiterten Variante werden die Leitungen auf dem Trägerelement untereinander abgeschirmt, um deren gegenseitige Beeinflussung zu unterdrücken. Diese Abschirmung kann als integraler Bestandteil des Trägerelementes ausgeführt sein.

In einer weiteren Ausführungsform sind die Benutzerschnittstellen als Betätigungselemente ausgebildet, welche aus der zweiten Kammer heraus die elektronischen Komponenten in der ersten Kammer ansteuern. Dadurch, dass die Betätigungselemente die elektronischen Komponenten über eine gewisse Entfernung fernsteuern, können alle, vorzugsweise eine hohe Leistung verarbeitenden elektronischen Komponenten, gemeinsam in der ersten Kammer untergebracht werden. Somit kann die erste Kammer hinsichtlich des Platzbedarfes relativ klein gehalten werden.

Vorteilhafterweise sind die Betätigungselemente als, vorzugsweise digitale, Schalter ausgebildet, deren Signale über die Schaltlogik gebündelt und seriell übertragen werden und insbesondere einen Feldbus terminieren und/oder eine Relais-Funktionalität auswählen und/oder eine Analog-Eingangs-/Ausgangs-Funktionalität auswählen. Da solche digitalen Schalter nur wenig Strom für ihre Schaltsignale benötigen, ist eine Anordnung außerhalb eines explosionsfesten Raumes problemlos möglich. Die Schaltsignale der digitalen Schalter werden ebenfalls durch die, mit einer geringen Leistung arbeitenden Schaltlogik gebündelt und seriell an die elektronischen Komponenten der ersten Kammer weitergeleitet.

In einer Ausgestaltung sind die Benutzerschnittstellen als LED, Tastatur und/oder Display ausgebildet. Aufgrund dieser Ausgestaltung sind alle Bauteile, welche eine höhere elektromagnetische Verträglichkeit aufweisen, in die zweite Kammer verlagert. Dies hat darüber hinaus den Vorteil, dass der Nutzer bei Wartung oder Einstellung des Prozesstransmitters nur auf eine Kammer zugreifen muss.

In einer Weiterbildung ist jede Kammer mit einer separaten Abdeckung versehen, wobei insbesondere die Abdeckung der ersten Kammer versiegelt ist. Da der Nutzer nur die Abdeckung für die zweite Kammer öffnen muss, wenn er den Prozesstransmitter justieren oder warten möchte, bleibt die erste Kammer vor jedem Umgebungseinfluss geschützt. Durch die Versiegelung der ersten Kammer wird auch gleichzeitig gekennzeichnet, dass sich in dieser Kammer keine Betätigungselemente befinden. Die erste Kammer muss lediglich nur dann geöffnet werden, wenn eine sich darin befindliche elektronische Komponente defekt ist.

In einer Variante ist die erste Kammer explosionsfest ausgebildet, während die zweite Kammer vorzugsweise einen ersten Bereich aufweist, in welchem Benutzerschnittstellen und/oder Anschlusselemente derart angeordnet sind, dass über den Abstand der elektrisch leitenden Elemente zueinander sichergestellt ist, dass kein Kurzschluss erzeugt wird und somit keine Zündung erfolgen kann, sowie einen zweiten Bereich umfasst, in welchem Benutzerschnittstellen und/oder Anschlusselemente angeordnet sind, die eine derart geringe Leistung umsetzen, dass sichergestellt ist, dass die Leistung keinen Funken erzeugen kann. Aufgrund dieser Ausgestaltung wird gewährleistet, dass die elektronischen Komponenten, welche eine hohe Energie für ihre Funktionsfähigkeit benötigen, und somit auch eine hohe Leistung umsetzen, alle in nur einer Kammer angeordnet sind, welche so ausgestaltet ist, dass bei einem eventuellen Fehlverhalten einer elektronischen Komponente, das einen Funken auslöst, was eine Explosion zur Folge hat, der Schaden auf die erste Kammer begrenzt bleibt. Ein Übergreifen der Explosion auf die zweite Kammer wird zuverlässig verhindert. Die zweite Kammer ist nach Kriterien des Explosionsschutzes in zwei Bereiche unterteilt. Der erste Bereich separiert die elektrisch leitenden Bauteile derart voneinander, dass kein Kurzschluss entstehen kann und wird als EX e-Bereich bezeichnet, welcher extra noch abgedeckt ist. Der zweite Bereich, welcher als Ex i-Bereich gestaltet ist, beinhaltet nur solche Bauteile, welche eine niedrige Leistung umfassen. Somit lässt sich die zweite Kammer des Gehäuses räumlich entsprechend den jeweiligen Anforderungen des Explosionsschutzes anpassen.

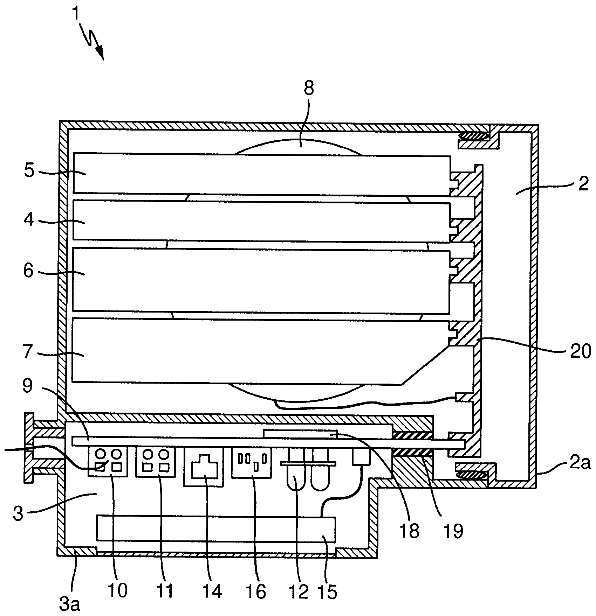

Die Erfindung lässt zahlreiche Ausführungsformen zu. Eine davon soll anhand der in der Zeichnung dargestellten Figur näher erläutert werden.

Es zeigt:
Figur: Schnittdarstellung durch eine Ausführungsform eines Prozesstransmitters.

Die Figur zeigt eine Schnittdarstellung durch eine Ausführungsform eines Prozesstransmitters 1 in einem Gehäuse. Das Gehäuse ist in zwei Kammern 2, 3 unterteilt. Die erste Kammer 2 wird als Elektronikraum und die zweite Kammer 3 als Anschlussraum bezeichnet. In der ersten Kammer 2 sind nur elektronische Komponenten angeordnet, wie Eingabe-/Ausgabe-Funktionalitäten 4, 5, ein Feldbus 6 sowie ein Netzteil 7. Unterhalb dieser erwähnten elektronischen Komponenten 4, 5, 6, 7 ist eine Messtechnik 8 angeordnet.

In der zweiten Kammer 3 ist ein Trägerelement in der Form einer Leiterplatte 9 positioniert, auf welcher sich verschiedene Anschlusselemente 10, 11 zur Aufnahme von externen Kabeln befinden. Darüber hinaus sind dort eine Serviceschnittstelle14 in Form einer RJ45 Schnittstelle und ein Display mit einer Tastatur 15 angeordnet. Eine Vielzahl von Mikroschaltern 16 und LEDs 12 sind weiterhin auf der Leiterplatte 9 positioniert. Eine Schaltlogik 18 in Form eines Mikroprozessors befindet sich ebenfalls auf der Leiterplatte 9. Da die Schaltlogik 18 nur digitale Signale weiterleitet, benötigt dieser nur einen geringen Strom.

Die Leiterplatte 9, welche in der zweiten Kammer 3 die beschriebenen Anschlusselemente 10, 11, die Serviceschnittstelle 14, das Display 15 sowie den die Mikroschalter 16, die LEDs 12 und die Schaltlogik 18 trägt, ragt mit einem freien Ende durch eine Gehäusedurchführung 19 in die erste Kammer 2. In der Gehäusedurchführung 19 ist die Leiterplatte 9 mit dem Gehäuse verklebt. Das in die erste Kammer 2 ragende Ende der Leiterplatte 9 wird elektromechanisch von einer Steckeinrichtung 20 aufgenommen, mit welcher auch die elektronischen Komponenten 4, 5, 6, 7, 8 verbunden sind.

Die elektronische Verbindung zwischen den, in der zweiten Kammer 3 angeordneten Displays 15 sowie den digitalen Mikroschaltern 16 und den LEDs 12 erfolgt über die Schaltlogik 18. Alle die genannten Bauteile führen mit, auf der Leiterplatte 9 ausgebildeten Leitungen an die Schaltlogik 18. Diese Schaltlogik 18 bündelt die zu übertragenden Informationen und überträgt diese seriell an die erste Kammer 2. Die von der Schaltlogik 18 ausgegebenen seriellen Signale werden über, an der Steckeinrichtung 20 ausgebildete elektrische Leitungen an die einzelnen elektronischen Komponenten, wie die Ein- und Ausgabe-Funktionalitäten 4, 5, den Feldbus 6 bzw. das Netzteil 7 und die Messtechnik 8 weitergeleitet.

Durch die Mikroschalter 16 kann beispielsweise der Feldbus in seiner Funktion terminiert, die Relaisfunktion normaly open oder normaly closed definiert, die analogen Eingangs-/Ausgangsfunktionalitäten zwischen aktiv und passiv umgeschaltet oder deren Funktion als Strom, Puls oder Frequenzausgang gewählt werden.

Die angeführten Anschlusselemente 10, 11 können als Steck-, Klemm- und/oder Schraubverbindung für je ein Kabel ausgebildet sein, die als Anschluss für den Feldbus 6 und/oder Eingangs-/Ausgangsfunktionalitäten 4, 5 verwendet werden. Das Display mit der Tastatur 15 ist zur Vorort-Bedienung des Prozesstransmitters 1 in der zweiten Kammer 3 positioniert. Darüber hinaus ist es auch möglich, Speichermodule in der zweiten Kammer 3 auf der Leiterplatte 9 vorzusehen, was in der Figur nicht weiter dargestellt ist. Auf solchen Speichermodulen ist die komplette Parametrierung des Prozesstransmitters1 gespeichert. Diese Parametrierung kann dabei eine Spiegelung der Prozessparameter sein, wie sie in den elektronischen Komponenten 4, 5, 6, 7 vorgesehen sind. Sie kann aber auch die aktuellen Daten des Prozesszustandes des Prozesstransmitters 1 widerspiegeln. Die Anordnung dieser Speichermodule in der ersten Kammer 3 ermöglicht eine freie Zugänglichkeit für den Nutzer.

In den beiden Kammern 2, 3 sind unterschiedliche Formen des Explosionsschutzes verwirklicht. So ist die erste Kammer 2, welche die elektronischen Komponenten 4, 5, 6, 7, 8 beinhaltet, für einen Ex d-Explosionsschutz ausgestaltet, während die zweite Kammer 3, welche den Anschluss- bzw. Benutzerschnittstellenraum darstellt, für einen Explosionsschutz nach den Regeln Ex e, Ex m und/oder Ex i ausgebildet ist. Ein Schutz nach der Regel Ex d bedeutet, dass eine druckfeste Kapselung des Gehäuses und somit ein explosionsfestes Gehäuse notwendig ist. Dadurch wird jederzeit verhindert, dass eine, durch eine elektronische Komponente 4, 5, 6, 7, 8 infolge eines Funkenschlages ausgelöste Explosion auf Bereiche außerhalb der ersten Kammer 2 übergreifen kann. Aus diesem Grund ist die Abdeckung 2a der ersten Kammer 2 mit der ersten Kammer 2 über ein flammensicheres Gewinde miteinander verbunden. Durch Anbringen einer zusätzlichen Verplombung zwischen der ersten Kammer 2 und der Abdeckung 2a kann nachgewiesen werden, dass die erste Kammer 2 nicht geöffnet wurde und die darin enthaltenen Komponenten nicht manipuliert wurden.

Um den verschiedensten Anforderungen des Explosionsschutzes gerecht zu werden, ist die zweite Kammer 3 in unterschiedliche Bereiche unterteilt, wobei in einem ersten Bereich, welcher nach der Regel Ex e gestaltet ist, elektrisch leitenden Bauteile voneinander derart separiert werden das kein Kurzschluss erzeugt werden kann. Dieser Bereich ist verdeckt, während ein, sich daran anschließender zweiter Bereich, der entsprechend der Regel Ex i ausgebildet ist, zugänglich gestaltet ist. Um die Regeln des Ex i Explosionsschutzes einzuhalten, wird die Energie, die den Komponenten in diesem Bereich zur Verfügung gestellt wird, derart begrenzt, dass diese nicht ausreicht, um einen Funken zu erzeugen.

Die Einführung von externen Kabeln in das Gehäuse des Prozesstransmitters 1 erfolgt derartig, dass die Kabel unmittelbar nach der Kabeleinführung auf die Anschlusselemente 10, 11 treffen. Dies hat den Vorteil, dass kein zusätzlicher Raum für die Kabelführung benötigt wird. Weiterhin können die Signale frühestmöglich gefiltert werden und somit die Störungen durch elektromagnetische Felder minimiert werden. Darüber hinaus ist es möglich, durch die direkte Zugänglichkeit den Schirm der Kabel unmittelbar nach Eintritt in das Gehäuse zu erden.

Wie bereits ausgeführt, ist die Abdeckung 2a mit der ersten Kammer 2 über ein flammensicheres Gewinde verbunden. Durch Anbringen einer zusätzlichen Verplombung zwischen der ersten Kammer 2 und der Abdeckung 2a kann nachgewiesen werden, dass die erste Kammer 2 nicht geöffnet wurde und die darin enthaltenen Komponenten nicht manipuliert wurden. Demgegenüber ist eine weitere Abdeckung 3a der zweiten Kammer 3 so ausgestaltet, dass sie problemlos geöffnet werden kann und einem Wartungspersonal den Zutritt zu den Anschlusselementen 10, 11, der Serviceschnittstelle 14, den digitalen Mikroschaltern 16 sowie den LEDs 12 gewährt. Da für die Wartung bzw. die Einstellung des Prozesstransmitters 1 nur die Abdeckung zur zweiten Kammer 3 geöffnet werden muss, ist eine bessere Zugänglichkeit zu dem Gehäuse des Prozesstransmitters 1 am Einbauort gegeben, da nur ein Zugang von einer Seite zu dem Gehäuse 1 notwendig ist.

Entscheidend ist, dass der Nutzer alle Schnittstellen des Gerätes 1, die er für die Wartung bzw. Programmierung benötigt, nur hinter der Abdeckung 3a in der zweiten Kammer 3 findet. Die Abdeckung 2a der ersten Kammer 2 ist nur zu öffnen, wenn die elektronischen Elemente 4, 5, 6, 7, 8 getauscht oder repariert werden müssen.

## Patentansprüche

1. Elektronisches Gerät mit einem Gehäuse zur Aufnahme elektronischer Komponenten, vorzugsweise ein Prozesstransmitter, wobei das Gehäuse zwei Kammern (2, 3) aufweist, in denen elektronische Komponenten (4, 5, 6, 7, 8) und Benutzerschnittstellen (12, 14, 15, 16) und/oder Anschlusselemente (10,11) für Kabel angeordnet sind, wobei die elektronischen Komponenten (4, 5, 6, 7) in einer ersten Kammer (2) angeordnet sind, und wobei in der ersten Kammer (2) ausschließlich elektronische Komponenten (4, 5, 6, 7, 8) angeordnet sind, während Benutzerschnittstellen (12, 14, 15, 16) der elektronischen Komponenten (4, 5, 6, 7, 8) und/oder Anschlusselemente (10, 11) für Kabel ausschließlich in der zweiten Kammer (2) positioniert sind, **dadurch gekennzeichnet, dass** die Benutzerschnittstellen (12, 14, 15, 16) und/oder die Anschlusselemente (10, 11) in der zweiten Kammer (2) auf einem Trägerelement (9) angeordnet sind, welches durch eine Gehäusedurchführung (19) in die erste Kammer (2) ragt, wobei das Trägerelement (9) von einer Steckeinrichtung (20) in der ersten Kammer (2) mechanisch aufgenommen ist, welche die auf dem Trägerelement (9) geführten elektrischen Leitungen der Benutzerschnittstellen (12,14, 15, 16) und/oder der Anschlusselemente (10,11) elektrisch mit den jeweiligen elektronischen Komponenten (4, 5, 6, 7, 8) verbindet.

2. Elektronisches Gerät nach Anspruch 1, **dadurch gekennzeichnet, dass** die Gehäusedurchführung (19) druckfest abgedichtet ist.

3. Elektronisches Gerät nach einem der vorherigen Ansprüche, **dadurch gekennzeichnet, dass** die Benutzerschnittstellen (12, 14, 15, 16) und/oder die Anschlusselemente (10, 11) an eine, in der zweiten Kammer (3), vorzugsweise auf dem Trägerelement (9), angeordnete Schaltlogik (18) führen, welche die elektrischen Signale der Benutzerschnittstellen (12, 14, 15, 16) mittels einer digitalen Kommunikation seriell an die jeweiligen elektronischen Komponenten (4, 5, 6, 7, 8) in der ersten Kammer (2) weiterleitet.

4. Elektronisches Gerät nach Anspruch 3, **dadurch gekennzeichnet, dass** die auf dem Trägerelement (9) ausgebildeten Leitungen einen Abstand aufweisen, welcher eine gegenseitige elektromagnetische Beeinflussung der übertragenen schnellen elektrischen Signale unterbindet.

5. Elektronisches Gerät nach mindestens einem der vorhergehenden Ansprüche, **dadurch gekennzeichnet, dass** die Benutzerschnittstellen (12, 14, 15, 16) als Betätigungselemente (16) ausgebildet sind, welche aus der zweiten Kammer (3) heraus die elektronischen Komponenten (4, 5, 6, 7, 8) in der ersten Kammer (2) ansteuern.

6. Elektronisches Gerät nach Anspruch 5, **dadurch gekennzeichnet, dass** die Betätigungselemente als, vorzugsweise digitale, Schalter (16) ausgebildet sind, deren Signale über die Schaltlogik (18) gebündelt und seriell übertragen werden und insbesondere einen Feldbus (6) terminieren und/oder eine Relais-Funktionalität auswählen und/oder eine Analog-Eingangs-/Ausgangs-Funktionalität (4, 5) auswählen.

7. Elektronisches Gerät nach einem der Ansprüche 1 bis 5, **dadurch gekennzeichnet, dass** die Benutzerschnittstellen als LED (12), eine Serviceschnittstelle (14) und/oder als Display (15) mit Tastatur ausgebildet sind.

8. Elektronisches Gerät nach mindestens einem der vorhergehenden Ansprüche, **dadurch gekennzeichnet, dass** jede Kammer (2, 3) mit einer separaten Abdeckung (2a, 3a) versehen ist, wobei insbesondere die Abdeckung (2a) der ersten Kammer (2) versiegelt ist.

9. Elektronisches Gerät nach mindestens einem der vorhergehenden Ansprüche, **dadurch gekennzeichnet, dass** die erste Kammer (2) explosionsfest ausgebildet ist, während die zweite Kammer (3) vorzugsweise einen ersten Bereich aufweist, in welchem Benutzerschnittstellen (12, 14, 15, 16) und/oder die Anschlusselemente (10, 11) derart angeordnet sind, dass über den Abstand der elektrisch leitenden Komponenten (10, 11, 12, 14, 15, 16) zueinander sichergestellt ist, dass kein Kurzschluss erzeugt wird und somit keine Zündung erfolgen kann, sowie einen zweiten Bereich umfasst, in welchem Benutzerschnittstellen (12, 14, 15, 16) und/oder Anschlusselemente (10, 11) angeordnet sind, die eine derart geringe Leistung umsetzen, so das sicher gestellt ist, dass die Leistung keinen Funken erzeugen kann.

10. Elektronisches Gerät nach einem der vorherigen Ansprüche, wobei die elektronischen Komponenten (4, 5, 6, 7, 8) Ein- und Ausgabe-Funktionalitäten (4, 5), einen Feldbus (6) sowie ein Netzteil (7) umfassen.

11. Elektronisches Gerät nach dem vorherigen Anspruch, wobei die elektronischen Komponenten (4, 5, 6, 7, 8) eine Messtechnik (8) umfassen.

## Claims

1. Electronic device with a housing designed to accommodate electronic components, preferably a process transmitter, wherein the housing has two chambers (2, 3) in which electronic components (4, 5, 6, 7, 8) and user interfaces (12, 14, 15, 16) and/or connection elements (10, 11) for cables are arranged, wherein the electronic components (4, 5, 6, 7) are arranged in a first chamber (2), and the first chamber (2) exclusively contains electronic components (4, 5, 6, 7, 8), whereas user interfaces (12, 14, 15, 16) of the electronic components (4, 5, 6, 7, 8) and/or connection elements (10, 11) for cables are arranged exclusively in the second chamber (3),
**characterized in that**
the user interfaces (12, 14, 15, 16) and/or the connection elements (10, 11) are arranged in the second chamber (3) on a support element (9) which projects into the first chamber (2) via a housing feed-through (19), wherein the support element (9) is accommodated mechanically in the first chamber (2) by a plug-in device (20) that electrically connects the electrical cables of the user interfaces (12, 14, 15, 16) and/or the connection elements (10,11), which are carried on the support element (9), with the individual electronic components (4, 5, 6, 7, 8).

2. Electronic device as claimed in Claim 1, **characterized in that** the housing feed-through (19) is sealed in a pressure-tight manner.

3. Electronic device as claimed in one of the previous claims, **characterized in that** the user interfaces (12, 14, 15, 16) and/or the connection elements (10, 11) lead to a switching logic system (18) arranged in the second chamber (3), preferably on the carrier element (9), wherein said switching logic system (18) serially communicates the electrical signals of the user interfaces (12, 14, 15, 16) to the electronic components (4, 5, 6, 7, 8) in the first chamber (2) via digital communication.

4. Electronic device as claimed in Claim 3, **characterized in that** the cables located on the support element (9) are spaced in a way that prevents the transmitted fast electrical signals from influencing each other electromagnetically.

5. Electronic device as claimed in at least one of the previous claims, **characterized in that** the user interfaces (12, 14, 15, 16) are designed as actuation elements (16), which control the electronic components (4, 5, 6, 7, 8) in the first chamber (2) from the second chamber (3).

6. Electronic device as claimed in Claim 5, **characterized in that** the actuation elements are designed as switches, preferably digital, whose signals are bundled via the switching logic system (18) and are transmitted serially and, in particular, establish the termination of a field bus (6) and/or select a relay functionality and/or an analog input/output functionality (4, 5).

7. Electronic device as claimed in one of the Claims 1 to 5, **characterized in that** the user interfaces are designed as an LED (12), a service interface (14) and/or as a display (15) with a keyboard.

8. Electronic device as claimed in at least one of the previous claims, **characterized in that** each chamber (2, 3) has a separate cover (2a, 3a), wherein in particular the cover (2a) of the first chamber (2) is sealed.

9. Electronic device as claimed in at least one of the previous claims, **characterized in that** the first chamber (2) is designed as an explosion-proof chamber, while the second chamber (3) preferably has a first area in which user interfaces (12, 14, 15, 16) and/or the connection elements (10, 11) are arranged in such a way that the distance of the electrically conductive components (10, 11, 12, 14, 15, 16) to one another ensures that a short-circuit does not occur and thereby no ignition can take place, and **in that** the chamber has a second area in which user interfaces (12, 14, 15, 16) and/or connection elements (10, 11) are arranged which use so little power that it is ensured that the power cannot generate any sparks.

10. Electronic device as claimed in one of the previous claims, wherein the electronic components (4, 5, 6, 7, 8) comprise input and output functionalities (4, 5), a fieldbus (6) and a power unit (7).

11. Electronic device as claimed in the previous claim, wherein the electronic components (4, 5, 6, 7, 8) comprise measuring technology (8).

## Revendications

1. Appareil électronique avec un boîtier destiné au logement de composants électroniques, de préférence un transmetteur de process, le boîtier comportant deux chambres (2, 3), dans lesquelles sont disposées des composants électroniques (4, 5, 6, 7, 8) et des interfaces utilisateur (12, 14, 15, 16) et/ou des éléments de raccordement (10, 11) pour câbles, les composants électroniques (4, 5, 6, 7) étant disposés dans une première chambre (2), et la première chambre (2) contenant exclusivement des composants électroniques (4, 5, 6, 7, 8), tandis que la deuxième chambre contient exclusivement les interfaces utilisateur (12, 14, 15, 16) des composants électroniques (4, 5, 6, 7, 8) et/ou les éléments de raccordement (10, 11) pour câbles,
**caractérisé**
**en ce que** les interfaces utilisateur (12, 14, 15, 16) et/ou les éléments de raccordement (10, 11) disposés dans la deuxième chambre (3) sont placés sur un élément support (9), lequel s'étend à travers un passage de boîtier (19) dans la première chambre (2), l'élément support (19) étant logé mécaniquement dans un dispositif enfichable (20) disposé dans la première chambre (2), lequel dispositif relie les câbles électriques posés sur l'élément support (9) des interfaces utilisateur (12, 14, 15, 16) et/ou des éléments de raccordement (10, 11) avec les différents composants électroniques (4, 5, 6, 7,8).

2. Appareil électronique selon la revendication 1, **caractérisé en ce que** le passage de boîtier (19) est étanche de manière à résister à la pression.

3. Appareil électronique selon l'une des revendications précédentes, **caractérisé en ce que** les interfaces utilisateur (12, 14, 15, 16) et/ou les éléments de raccordement (10, 11) aboutissent à une logique de commande (18) disposée dans la deuxième chambre (3), de préférence sur l'élément support (9), laquelle logique transmet en série les signaux électriques des interfaces utilisateur (12, 14, 15, 16) au moyen d'une communication numérique aux différents composants électroniques (4, 5, 6, 7, 8) disposés dans la première chambre (2).

4. Appareil électronique selon la revendication 3, **caractérisé en ce que** les câbles posés sur l'élément support (9) présentent une distance telle à empêcher une influence électromagnétique mutuelle des signaux électriques rapides transmis.

5. Appareil électronique selon au moins l'une des revendications précédentes, **caractérisé en ce que** les interfaces utilisateur (12, 14, 15, 16) sont conçues en tant qu'éléments d'actionnement (16), lesquels commandent depuis la deuxième chambre (3) les composants électroniques (4, 5, 6, 7, 8) disposés dans la première chambre (2).

6. Appareil électronique selon la revendication 5, **caractérisé en ce que** les éléments d'actionnement sont conçus de préférence en tant qu'interrupteurs numériques (16), dont les signaux sont regroupés par l'intermédiaire de la logique de commande (18) et sont transmis en série, et établissent notamment la terminaison d'un bus de terrain (6) et/ou sélectionnent une fonctionnalité de relais et/ou sélectionnent une fonctionnalité d'entrée/sortie analogique (4, 5).

7. Appareil électronique selon l'une des revendications 1 à 5, **caractérisé en ce que** les interfaces utilisateur sont conçues sous forme d'une LED (12), d'une interface de service (14) et/ou d'un afficheur (15) avec clavier.

8. Appareil électronique selon au moins l'une des revendications précédentes, **caractérisé en ce que** chaque chambre (2, 3) est munie d'un couvercle (2a, 3a), le couvercle (2a) de la première chambre (2) étant notamment scellé.

9. Appareil électronique selon au moins l'une des revendications précédentes, **caractérisé en ce que** la première chambre (2) est conçue de façon antidéflagrante, tandis que la deuxième chambre (3) présente de préférence une première zone, dans laquelle les interfaces utilisateur (12, 14, 15, 16) et/ou les éléments de raccordement (10, 11) sont disposés de telle sorte à garantir, à travers la distance entre les différents composants électroconducteurs (10, 11, 12, 14, 15, 16), l'absence de court-circuit et, par conséquent, l'absence d'étincelle, lequel appareil présente également une deuxième zone, dans laquelle sont disposés les interfaces utilisateur (12, 14, 15, 16) et/ou les éléments de raccordement (10, 11), qui consomment une puissance suffisamment faible pour garantir que la puissance ne générera pas d'étincelle.

10. Appareil électronique selon l'une des revendications précédentes, **caractérisé en ce que** les composants électroniques (4, 5, 6, 7, 8) comprennent des fonctionnalités d'entrée et de sortie (4, 5), un bus de terrain (6) ainsi qu'un bloc d'alimentation (7).

11. Appareil électronique selon la revendication précédente, **caractérisé en ce que** les composants électroniques (4, 5, 6, 7, 8) comprennent une technique de mesure (8).
